# EUROPEAN PATENT APPLICATION

(11) **EP 1 930 944 A2**
(43) Date of publication of application: **11.06.2008**
(21) Application number: 07120982.9
(22) Date of filing: 19.11.2007
(51) Int. Cl.: H01L 23/36

(54) **Wafer applied thermal-mechanical interface**

(30) Priority: 05.12.2006 US 633936
(71) Applicant: Delphi Technologies, Inc., Troy, Michigan 48007 (US)
(72) Inventor: Oman, Todd P., Greentown, IN 46936 (US); Claucherty, Gordon A., Kokomo, IN 46902 (US)
(74) Representative: Denton, Michael John

(57) **Abstract**

An improved semiconductor assembly that provides a highly efficient heat-dissipating property, while also providing enhanced mechanical properties, includes a semiconductor device mounted on a substrate, a layer of low modulus material laminated to the semiconductor device, and a heat-conductive member urged against the low modulus layer to provide improved mechanical isolation between the semiconductor and the heat-dissipating member.

## Description

### Technical Field

This invention relates to semiconductor packages and more particularly heat-dissipating semiconductor packages that are more mechanically robust.

### Background of the Invention

Heat-dissipating assemblies for removing heat from a flip chip semiconductor device are disclosed in U.S. Patent Nos. 6,180,436 and 6,365,964, which are incorporated by reference in their entireties. The assemblies include a housing having a thermally-conductive portion, a flip chip mounted on a circuit contained in the housing, heat-conductive pedestals for conducting heat from the flip chip to one of the thermally-conductive portions of the housing, and a biasing means that urges the flip chip into engagement with the pedestals so that the pedestals are able to conduct heat away from the flip chip. A thermally-conductive lubricant is disposed between the flip chip and the heat-conductive member to fill gaps between the flip chip and the heat-conductive member to promote thermal contact while also decoupling lateral mechanical strains that may arise as a result of differences between the thermal expansion coefficients of the flip chip and the heat-conductive member.

However, in those cases where the assembly must be able to function reliably during and after frequent exposures to externally applied shocks and vibrations, as is often the case for motor vehicle applications, an improved assembly is desirable. With the known assemblies, the flip chip may be cracked by the force imparted on the brittle silicon components of the flip chip by the pedestal heatsink, which transmits mechanical energy (shocks and vibrations) through the thermal interface material (i.e., a thermally-conductive lubricant).

Another potential cause of damage to the flip chip in the known assemblies can arise from particulate contaminants in the thermally-conductive lubricant that are inadvertently deposited on surfaces of the heat-conductive pedestals or flip chip, and/or dispersed in the lubricant. Such particles can create a high stress point on the flip chip, which can cause cracking of a silicon component of the flip chip.

### Summary of the Invention

The invention provides a highly efficient heat-dissipating semiconductor assembly that exhibits improved mechanical isolation between the semiconductor device and a heat-conductive member in thermal contact with the semiconductor device and/or an improved interface between the semiconductor device and the heat-conductive member to facilitate relative movement of the heat-conductive member with respect to the semiconductor device in a plane generally defined by the interface, thereby minimizing stress on solder joints.

In accordance with an embodiment of the invention, there is provided a semiconductor assembly including a substrate, a semiconductor device mounted on the substrate, at least one layer of functional material laminated to a surface of the semiconductor device opposite a surface of the semiconductor device mounted adjacent to the substrate, a heat-conductive member in contact with the layer of functional material, and a compressible biasing member urging the layer of functional material against the heat-conductive member.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying:

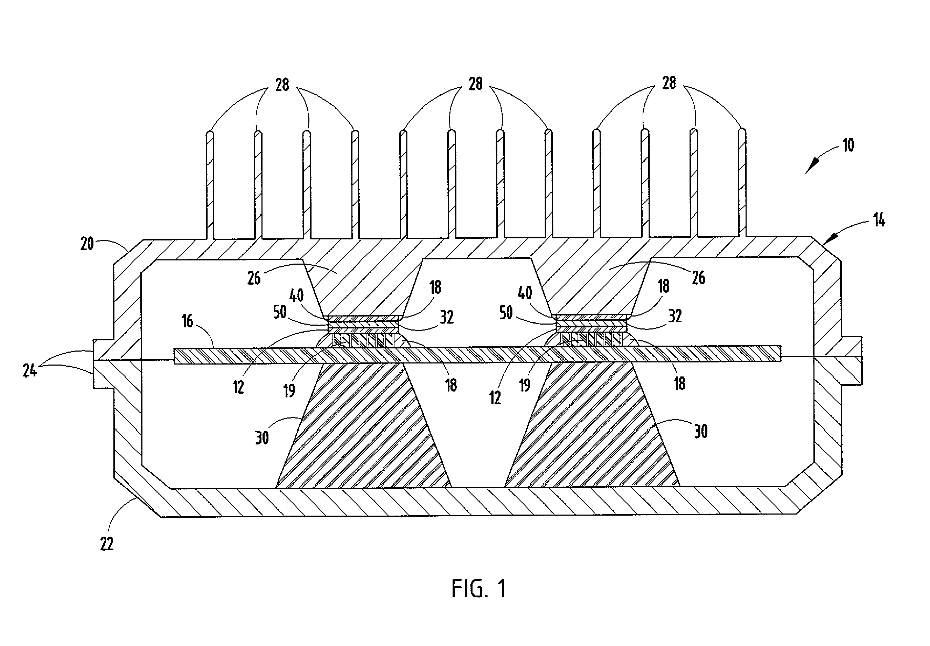

FIG. 1 shows a semiconductive assembly in accordance with an illustrative embodiment of the invention.

### Description of the Preferred Embodiments

The semiconductor assemblies of this invention generally comprise a semiconductor assembly similar to those disclosed in U.S. Patent Nos. 6,180,436 and 6,365,964, which is modified to include at least one layer of functional material laminated to a surface of the semiconductor device that is opposite a surface of the semiconductor device that is mounted adjacent a substrate, and thereby is disposed between the semiconductor device and a heat-conductive member in thermal contact with the semiconductor device.

The semiconductor device may generally comprise any type of semiconductor component or device, including resistors, diodes, transistors and the like, but is expected to the most beneficially employed for dissipating heat away from integrated circuit devices such as power flip chips. The substrate is desirably sufficiently flexible to allow a compressible biasing member to urge the substrate carrying the semiconductor device and the layer of functional material laminated to the semiconductor device against a heat-conductive member. In general, it is desirable that the substrate have a modulus of elasticity that is lower than that of silicon, i.e., the substrate should be more flexible than the semiconductor device.

A layer of functional material laminated to the semiconductor device refers to a layer of solid material that is relatively strongly adhered to a surface of the semiconductor device such that it cannot be easily peeled away from the semiconductor device. Processes that may be employed for laminating a functional layer on a surface of a semiconductor device include various physical and chemical deposition techniques (sputtering, chemical vapor deposition, plasma deposition, etc.), casting of metals (such as solders), application of a thermosettable resin to the surface of the semiconductor device followed by cross-linking or curing of the resin, etc.

The compressible member for urging the layer of functional material against the heat-conductive member may comprise generally any type of resiliently deformable material (e.g., elastomeric material) or mechanical device (e.g., a coil or leaf spring) that is capable of being compressed and which is capable of exerting a mechanical biasing force on adjacent members when it is in a compressed state. As disclosed in U.S. Patent No. 6,180,436, a suitable compressible biasing member may exert a force of from about 3 to 5 pounds (about 13 to about 22 Newtons), although lower and higher loads are foreseeable and may be used if desired.

The figure shows a heat-dissipating assembly 10 including a semiconductor device 12 (e.g., a power flip chip) mounted on a substrate 16 via solder connections 18. An underfill 19 comprised of a polymeric material may be disposed in the space between substrate 16 and semiconductor device 12 which is not occupied by solder connections 18. The underfill surrounds or encapsulates solder connections 18 to prolong the thermal cycle life of the solder connections and/or to protect the solder connections from chemical attack (such as from moisture vapor).

On a side or surface of semiconductor device 12 opposite a side or surface mounted adjacent substrate 16 there is laminated at least one layer 40 of a functional material. However, multiple layers of functional materials may be laminated onto the surface of the semiconductor device. In the illustrated embodiment of the figure, a functional layer 50 is first laminated to a surface of semiconductor device 12, and thereafter a second functional layer 40 is laminated over functional layer 50.

In the illustrated embodiment, the heat-conductive members 26 are pedestals projecting away from the inner wall of a first housing member 20. In this embodiment, the heat-conductive members are integrally formed with housing member 20. However, heat-conductive members 26 could be separately formed and subsequently attached to a housing member. As shown in the illustrated embodiment of the figure, a plurality of convection cooling fins 28 are provided to help radiate heat away from the assembly 10.

In the illustrated embodiment shown in the figure, compressible biasing members 30 are disposed between substrate 16 and a second housing member 22 connected to first housing member 20 at flanges 24. Desirably, at least housing member 20 is composed of a material having a relatively high thermal conductivity, such as a metal (e.g., aluminium) or a metal-filled plastic. While lower housing member 22 need not be formed of a heat-conducting material, it is foreseeable to do so to provide a larger heatsink. Lower housing member 22 may also be equipped with cooling fins to further promote heat dissipation to the environment. The choice of material for lower housing member 22 may depend in part on the type of biasing member 30 used, since a metallic spring could promote conduction of heat back to the flip chip 12 if the lower housing member 22 is also thermally conductive.

As shown in the figure, a thermally-conductive lubricant 32 may also be provided between the layer or layers of functional material laminated to the semiconductor device. Lubricant 32 may serve to decouple lateral mechanical strains that can arise as a result of different thermal expansions and movement between semiconductor device 12, substrate 16 and heat-conductive members 26. Various lubricants are known for this purpose, with a suitable lubricant being a silicon grease available from Dow Chemical. It is foreseeable that other heat-conducting materials having suitable lubricating properties could be used.

At least one of the functional layers 40 is a low modulus layer which is more flexible than silicon and typically more flexible than the heat-conductive member, whereby semiconductive device 16 is mechanically isolated or decoupled from heat-conductive member 26. In addition to having a lower modulus of elasticity lower than the brittle components (e.g., silicon) of semiconductor device 16, functional layer 50 also has a suitably high thermal conductivity, preferably comparable to the thermal conductivity of heat-conductive member 26. Examples of suitable materials for forming low modulus functional layer 50 include graphite filled epoxy resins, boron nitride, thermally-conductive adhesives, and various solders. A preferred material on account of its relatively low modulus and relatively high thermal conductivity is graphite filled epoxy resins, such as Part No. ATTA LP-1, which is available from B-Tech Corporation. Examples of solders that may be employed include bismuth, cadmium-silver, cadmium-zinc, indium, lead-silver, tin-antimony, tin-antimony-lead, tin-lead, tin-silver, tin-zinc and zinc-aluminum solders, with preferred solders including bismuth and indium solders based on their high flexibility (low modulus).

In addition to mechanically isolating or decoupling semiconductor device 16 from heat-conductive member 26, low modulus layer 50 may also be employed to provide an interface between heat-conductive member 26 and a high modulus layer 40 (such as a metal or ceramic layer) to facilitate movement in a plane generally coinciding with the interface between heat-conductive member 26 and semiconductor device 16, and thereby minimizing stress on solder joints 18. In addition, a ceramic high modulus layer 40 allows heat-conductive member 26 to be fabricated more economically when electrical isolation is required between the semiconductor device and the heat-conductive member. In addition, the high modulus layer 40 can eliminate or reduce the amount of machining of the surface of heat-conductive member 26 that would be required to prevent mechanical damage to a bare (non-laminated) semiconductor device 16. High modulus layer 30 may also be employed to protect the backside of semiconductor device 16 (i.e., the side opposite the side at which semiconductor device 16 is attached to substrate 16) from scratches due to mechanical handling, during wafer testing, wafer mounting, wafer sawing, die sorting and/or board assembly. These advantages also provide the potential to eliminate a visual inspection step after underfilling of assembly 10.

Except for the additional steps of applying layer 50 and optional layer 40, the process for manufacturing semiconductor assembly 10 is otherwise substantially unchanged from the processes disclosed in U.S. Patent Nos. 6,180,436 and 6,365,964.

An advantage with the assemblies of the invention is that the specifications for the number of particles and the size of particles in thermal grease 32 can be relaxed. This in turn may facilitate the use of thermal greases having higher amounts of thermally-conductive particles that could potentially further improve thermal conductivity. When applied at the water level, high or low modulus layer 50 and optional high modulus layer 40 may also facilitate sharp needle die sorting for improved throughput, thereby lowering the cost of manufacturing semiconductor assembly 10. Low modulus layer 50 also reduces semiconductor device cracking due to a variety of external influences such as the number and size of particles in thermally-conductive lubricant 32, particle contaminants deposited on semiconductor device 12 and/or heat-conductive member 26, burrs or other irregularities on the surface of heat-conductive member 26 and/or underfill material on top of semiconductor device 12.

High modulus layer 40 preferably has a modulus of elasticity that is about equal to or greater than the modulus of elasticity of silicon. Examples of suitable materials for high modulus layer 50 include nickel-gold alloys, copper, aluminium, and ceramics such as silicon nitride and aluminium nitride.

Layer 40 and optional layer 50 are preferably applied at the wafer level (i.e., at a point in the manufacturing process before a plurality of devices being manufactured on a single substrate are sawed or otherwise singulated into individual devices), but may also be applied on the device level.

The invention also pertains to a method for conducting heat from a semiconductor device. The method comprises providing a substrate having conductors thereon, mounting a semiconductor device on the flexible substrate, laminating at least one layer of functional material to a surface of the semiconductor device opposite the surface adjacently mounted to the substrate, positioning a heat-conductive member in contact with the layer of functional material, and urging the layer of functional material against the heat-conductive member.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A semiconductor assembly comprising:
a substrate;
a semiconductor device mounted on the substrate, the semiconductor device having a first surface adjacent the substrate and a second surface opposite the first surface;
at least one layer of functional material laminated to the second surface of the semiconductor device;
a heat-conductive member in contact with the layer of functional material; and
a compressible biasing member urging the layer of functional material against the heat-conductive member.

2. The assembly of claim 1, wherein the at least one layer of functional material comprises a material having a lower modulus of elasticity than silicon.

3. The assembly of claim 1, wherein the at least one layer of functional material is a graphite filled epoxy resin.

4. The assembly of claim 1, wherein the at least one layer of functional material is boron nitride.

5. The assembly of claim 1, wherein the at least one layer of functional material is a solder.

6. The assembly of claim 5, wherein the solder is a bismuth solder.

7. The assembly of claim 5, wherein the solder is an indium solder.

8. The assembly of claim 1, comprising at least two layers of functional material laminated to the second surface of the semiconductor device, including a first layer having a a modulus of elasticity greater than or about equal to that of silicon, and a second layer having a modulus of elasticity less than that of silicon.

9. The assembly of claim 8, wherein the first layer is composed of a metal, metal alloy or ceramic.

10. The assembly of claim 9, composed of copper or aluminum.

11. The assembly of claim 9, wherein the first layer is a nickel-gold alloy.

12. The assembly of claim 9, wherein the first layer is a ceramic.

13. The assembly of claim 12, wherein the ceramic is silicon nitride or aluminum nitride.

14. The assembly of claim 1, further comprising a thermally-conductive grease disposed within the interface between the heat-conductive member and the layer of functional material.

15. A method of conducting heat from a semiconductor, the method comprising the steps of:
providing a substrate having conductors thereon;
mounting a semiconductor device to the substrate, the semiconductor device having a first surface adjacent the substrate and a second surface opposite the first surface;
laminating at least one layer of functional material to the second surface of the semiconductor device; and
urging the heat-conductive member against the layer of functional material.
